# EUROPEAN PATENT SPECIFICATION

(11) **EP 3 118 857 B1**
(45) Date of publication and mention of the grant of the patent: **03.04.2019**
(21) Application number: 16771914.5
(22) Date of filing: 12.02.2016
(51) Int. Cl.: H01B 3/28, H01B 5/00, H01L 21/60, H05K 3/32, H01B 1/02, H01B 5/14, H05K 1/18

(54) **CONDUCTIVE BALL**
LEITFÄHIGER BALL
BILLE CONDUCTRICE

(30) Priority: 30.03.2015 JP 2015067919
(43) Date of publication of application: 18.01.2017
(73) Proprietor: Little Device Corporation, Hiki-gun, Saitama 355-0327 (JP)
(72) Inventor: TAKIZAWA, Akimichi, Hiki-gun Saitama 355-0327 (JP)
(74) Representative: Plougmann Vingtoft a/s
(86) International application number: PCT/JP2016/054119
(87) International publication number: WO 2016/158030

(56) References cited:
- WO-A1-2014/061545
- JP-A- 2000 228 455
- JP-A- 2000 228 455
- JP-A- 2001 011 503
- JP-A- 2001 011 503

## Description

### TECHNICAL FIELD

The present invention relates to a conductive ball, which is coated tightly with a noble metal or the like being capable of providing improved properties such as heat resistance and electrical properties, and which can be used as a connector by intervening between electrodes to apply a current between the electrodes.

### BACKGROUND ART

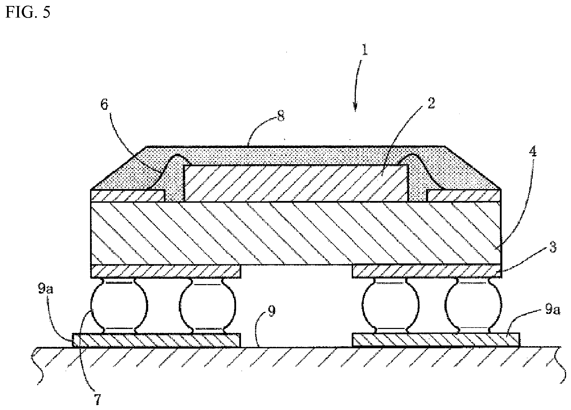

Conventionally, with miniaturization of electrical and electronic devices, when an electronic parts of a semiconductor apparatus or the like is mounted on a mounting substrate, it is becoming important to increase the packaging density on the mounting substrate. As a method of increasing the packaging density, BGA (Ball Grid Array) IC package has been developed in place of conventionally used pin type IC package. As shown in FIG. 5, the BGA IC package 1 has a semiconductor chip 2, a resin substrate 4 on which the semiconductor chip 2 is mounted, and solder balls 7 which are positioned under the lower surface of the resin substrate 4 and which are electrically connected to the semiconductor chip 2 via a bonding wire 6 and an electrode 3.

The conventional solder ball 7 is formed of solder metal only, and the semiconductor chip 2 and the bonding wire 6 are sealed with a sealing resin 8. When the BGA IC package 1 is mounted on a mounting substrate 9, each of the solder balls 7 of the BGA IC package 1 is positioned on a solder land 9a on the wiring pattern of the mounting substrate 9 and each of the solder balls 7 is melted and solidified to connect the BGA IC package 1 to the mounting substrate 9 electrically and mechanically.

However, the solder ball 7 of the conventional BGA IC package 1 has a problem of decreasing the reliability of the electrical connection and structural joining between the BGA IC package 1 and the mounting substrate 9 because the solder ball 7 is melted and crashed, or if not, the solder ball 7 is cracked or damaged when the BGA IC package 1 is mounted on the mounting substrate 9 by soldered joints or when it is subjected to the following thermal history.

In order to overcome the problem, a solder ball in which a sphere having a resistance of crash by heat is covered with a solder metal has been proposed (for example, see Patent Document 1). Specifically, the solder ball has a sphere which is composed of an organic material having heat resistance and having a diameter of 200 to 800 µm, and a solder metal shell applied so as to coat the surface of the sphere.

Using joints of the solder balls, since the solder ball has a sphere having a resistance of crash by heat, the solder ball is not crashed by heating under jointing and the following thermal history. Even if deforming stress occurs due to a difference in thermal expansion by heating under jointing and the following thermal history, the stress is absorbed by elasticity of the elastic organic material having heat resistance as the component of the sphere, and thus, it was expected that the reliability of the solder joints is increased by preventing the solder ball from cracking and crashing. In addition, document JP 2001 011503 relates to a conductive fine particle consisting of a spherical core particle, an elastic coating layer formed on the surface of the spherical core particle and a conductive thin film layer formed on the surface of the elastic coating layer.

### PATENT DOCUMENT

Patent Document 1: JP 2000-228455 A

### SUMMARY OF THE INVENTION

### PROBLEM TO BE SOLVED BY THE INVENTION

In the recent year, there is a need for a connector applying a current between electrodes without melting solder. Therefore, the method for electrically connecting electrodes is expected by intervening the conventional solder ball between electrodes and connecting between them.

However, if the elastic modulus of the solder ball formed by coating the sphere with the metal shell is high, electrodes and the solder ball are only contacted at a point when the solder ball is pressed on the flat surface of electrodes, and thereby required contact area cannot be obtained, and the electric resistance is increased.

Additionally, if the elastic modulus is high, the solder ball itself cannot be deformed. Therefore, in the case where a plurality of solder balls are used and they have various outer diameters, there is a problem that only the bigger solder ball is contacted to the electrodes, and the other smaller solder balls are not contacted to the electrodes and don't act as the connecter.

In order to ensure the contact area, the method for increasing the contact area between the metal shell and electrodes is expected by forming the sphere of the solder ball with an elastic body having low elastic modulus and allowing the deformation of the solder ball when the solder ball is pressed on the flat surface of the electrode.

However, the coefficient of thermal expansion of the elastic body as the component of the sphere is generally higher than that of the metal as the component of the metal shell. Therefore, when the surface of the sphere composed of the elastic body having higher coefficient of thermal expansion is coated with the metal having lower coefficient of thermal expansion to form the metal shell, there is a problem that the thermal expansion of the sphere is bigger than that of the metal shell due to the following thermal history, and the metal shell formed on the outer surface of the sphere is ruptured and the metal shell is cracked. When the metal shell is cracked, there is a problem that the conductivity of the metal shell is decreased and then the conductivity between electrodes is decreased. Therefore, the conductive ball has a sphere formed of an elastic body and a metal shell formed on the surface of the sphere has a problem that the usable temperature range is particularly limited so that the metal shell is not cracked.

An object of the present invention is to provide a conductive ball, which can be used as a connector by intervening between electrodes to apply a current between the electrodes with relatively high conductivity, and which is prevented from decreasing the conductivity due to the following thermal history.

### MEANS OF SOLVING THE PROBLEM

The conductive ball of the present invention comprises a sphere formed of an elastic body; a thermal expansion-resistant resin shell applied so as to coat the surface of the sphere; and a conductive metal shell applied so as to coat the outer surface of the thermal expansion-resistant resin shell.

In this case, the sphere has a diameter of 0.04 to 2 mm, the sphere is formed of a rubber, and the rubber further preferably has a heat resistance of 200°C or more.

The thermal expansion-resistant resin shell is formed of a polyimide which preferably has properties of a tensile strength of 1 to 700 MPa at a temperature of -40°C to 400°C and a heat resistance of 200°C or more. The thickness of the thermal expansion-resistant resin shell is preferably from 1% to 20% of the diameter of the sphere.

The conductive metal shell is preferably formed of copper, gold, silver, or palladium, or an alloy containing it. The thickness of the conductive metal shell is preferably from 0.1% to 10% of the diameter of the sphere.

### EFFECT OF THE INVENTION

The present invention can provide a conductive ball, which can be used as a connector by intervening between electrodes to apply a current between the electrodes with relatively high conductivity, and which is prevented from decreasing the conductivity due to the following thermal history.

### BRIEF DESCRIPTION OF DRAWINGS

FIG. 1 is a sectional view which shows a structure of a conductive ball according to one embodiment of the present invention.
FIG. 2 is a sectional view enlarging A section in FIG. 4 which shows a conductive ball according to one embodiment of the present invention sandwiched between electrodes.
FIG. 3 is showing a method for forming a thermal expansion-resistant resin shell on the surface of the sphere.
FIG. 4 is a sectional view which shows an IC package mounted on a mounting substrate by using conductive balls according to one embodiment of the present invention as a connector.
FIG. 5 is a sectional view which shows an IC package mounted on a mounting substrate by using conventional solder balls.

### MODE FOR CARRYING OUT THE INVENTION

Next, the best mode of the present invention will be described with reference to the drawings.

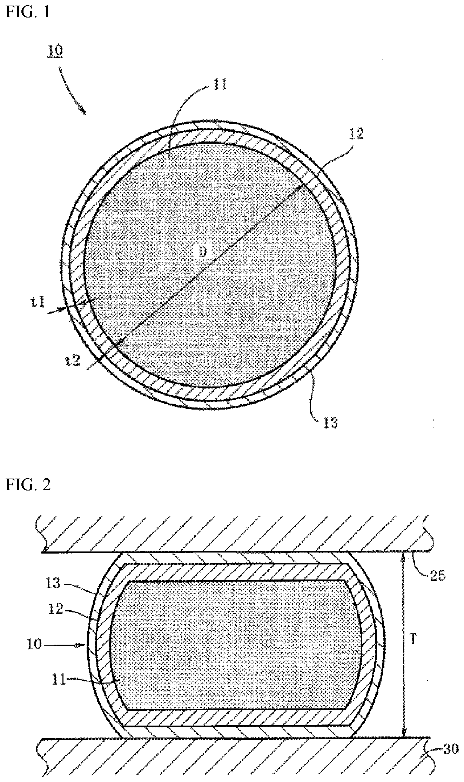

FIG. 1 is a sectional view showing a structure of a conductive ball 10 according to one embodiment of the present invention. As shown in FIG. 1, the conductive ball 10 of the present invention has a sphere 11 formed of an elastic body; a thermal expansion-resistant resin shell 12 applied so as to coat the surface of the sphere 11; and a conductive metal shell 13 applied so as to coat the outer surface of the thermal expansion-resistant resin shell 12.

The elastic body as the component of the sphere 11 is any material as long as it has elasticity and can be shaped into the sphere 11, for example, rubbers can be used. Examples of the rubber include natural rubbers formed of sap of a gum tree (latex) and synthetic rubbers which are synthesized artificially. Examples of the synthetic rubbers include styrene-butadiene rubbers, isoprene rubbers, butadiene rubbers, chloroprene rubbers, acrylonitrile-butadiene rubbers, butyl rubbers, ethylene-propylene rubbers, ethylene-propylene-diene rubbers, urethane rubbers, silicone rubbers, and fluorine rubbers. Among them, silicone rubbers (organic silicones) are preferably used.

Considering the use of the conductive ball 10 of the present invention as the connector which connects between electrodes, the diameter D of the sphere 11 is preferably from 0.04 to 2 mm. Also, as shown in FIG. 2, the sphere 11 preferably has an elastic modulus so that the diameter D was decreased by 1% to 30% when a flat electrode is placed on the sphere at a load of 2 g to 5 g. Preferably, the diameter D returns to the original one when the load is removed.

When the diameter of the sphere 11 is 0.04 mm or more, the sphere 11 can be easily handled as the connecter regardless of the properties of the device of interest. When the diameter of the sphere 11 is 2.0 mm or less, the packaging density in which can be increased in the case where the conductive ball 10 of the present invention is used as the connector and electronic parts on which electrodes are formed are mounted on a mounting substrate. Therefore, the diameter of the sphere 11 is preferably from 0.04 to 2 mm, more preferably from 0.1 to 1 mm, and further preferably from 0.2 to 0.5 mm.

The load applied from the electrode is from 2 g to 5 g for measuring the elastic modulus because the applied load of the conductive ball 10 is generally in the range when electric parts are mounted on the mounting substrate. If the diameter of the sphere 11 is decreased by 1% or more when the electrode is placed on the sphere at a load of 2 g to 5 g, the contact area sufficient for contacting the electrode and the conductive metal shell 13 can be obtained, and thus the problem of increasing the electric resistance can be decreased. If the diameter of the sphere 11 is decreased by 30% or less when the electrode is placed on the sphere at a load of 2 g to 5 g, the conductive metal shell 13 formed on the outer surface of the sphere 11 is prevented from damaging due to the deformation of the sphere 11. Therefore, the sphere 11 preferably has an elastic modulus so that the diameter D is decreased by 1% to 30%, more preferably by 3% to 20%, and further preferably by 5% to 15% when a flat electrode was placed on the sphere at a load of 2 g to 5 g.

Considering the use of the conductive ball 10 of the present invention as the connector which connects between electrodes, the sphere 11 is preferably composed of a rubber having a heat resistance of 200°C or more. More preferably, sphere 11 is composed of a silicone rubber having a heat resistance of 200°C or more.

Since silicone rubbers have improved heat resistance, water resistance, and chemical resistance, silicone rubbers can tolerate under using condition as the connector. When the sphere 11 is formed of a silicone rubber having a heat resistance of 200°C or more, the usable temperature range of the conductive ball 10 of the present invention can be remarkably widened.

When the sphere 11 is composed of a rubber (in particular, a silicone rubber) having an onset degradation temperature of more than 250°C, even if the sphere 11 is used at a relatively high temperature, the sphere 11 can be prevented from degrading, and gas generated due to the degradation can be prevented from accumulating in the thermal expansion-resistant resin shell 12, and the conductive metal shell 13 can be prevented from damaging due to the accumulation of gas.

Therefore, when the elastic body as the component of the sphere 11 has a heat resistance of 200°C or more, the sphere 11 can be used as the connecter being capable of tolerating the thermal history. The elastic body as the component of the sphere 11 preferably has a heat resistance of 250°C or more, and more preferably, more than 300°C and 400°C or less. The word "heat resistance" as used herein means the temperature in which the percent of the weight loss becomes 1% in thermogravimetric analysis (TGA) according to JIS K7120.

For forming the conductive ball 10, the sphere 11 composed of an elastic body is firstly formed. Examples of the method for forming the sphere 11 includes providing a required amount of an elastic body in a liquid form to form a sphere by the surface tension. Examples thereof also include providing a mold for the sphere 11 and injecting an elastic body in a liquid form into the mold to form a sphere 11. Examples thereof further include rolling and rubbing a determined amount of an elastic body with a pair of mold to form a sphere 11.

The surface of the sphere 11 formed of the elastic body is coated with a thermal expansion-resistant resin shell 12. By the thermal expansion-resistant resin shell 12, the sphere 11 formed of the elastic body is prevented from expanding by heat, and the conductive metal shell 13 formed on the thermal expansion-resistant resin shell 12 is prevented from damaging. Therefore, resins which may be a component of the thermal expansion-resistant resin shell 12 may be any resin as long as the resin can coat the surface of the sphere 11 and the resin can prevent the sphere 11 from expanding while coating the sphere 11. However, when the conductive ball 10 of the present invention is used as the connector, the thermal expansion-resistant resin shell 12 composed of a resin having properties of a tensile strength of 1 to 700 MPa at a temperature of -40°C to 400°C and a heat resistance of 200°C or more is preferably formed on the surface of the sphere 11. The term "tensile strength" as used herein means the strength resulted from the tensile test according to JIS K7161.

Preferred examples of the resin having properties of a tensile strength of 1 to 700 MPa at a temperature of -40°C to 400°C and a heat resistance of 200°C or more is polyimides. In other words, the thermal expansion-resistant resin shell 12 is preferably formed of a polyimide or a material containing a polyimide. As the material containing a polyimide, for example, a composite material containing a polyimide mixed with CNF (cellulose nanofiber) can be used for further decreasing the coefficient of linear thermal expansion.

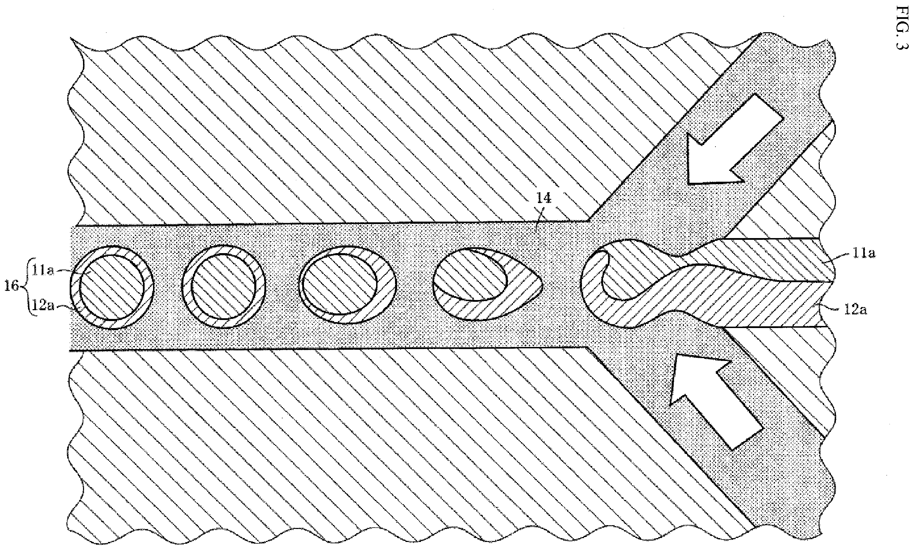

Examples of the method of forming the thermal expansion-resistant resin shell 12 on the surface of the sphere 11 include, for example, as shown in FIG. 3, supplying a liquid resin 12a for the thermal expansion-resistant resin shell 12 and a liquid elastic body 11 to be embodied in the thermal expansion-resistant resin shell 12 to a continuous flow of an aqueous medium 14 (for example, JP 2004-290977 A). As the materials used, for example, the elastic body 11a is a silicone rubber, the liquid resin 12a is a polyimide solution in which the solvent NMP (N-methylpyrrolidone) is replaced with toluene, and the aqueous medium is water.

FIG. 3 shows forming the liquid drops 16 by flowing the liquid resin 12a and the liquid elastic body 11a in parallel to form liquid drops, and coating the surface of the liquid elastic body 11a which becomes the sphere 11 due to the difference between the surface tensions of these two materials 11a and 12a with the liquid resin 12a having a uniform thickness.

The liquid drops 16 obtained by coating the surface of the liquid elastic body 11a which becomes the sphere 11 with the liquid resin 12a is then removed from the aqueous medium 14 and solidified by heat polymerization. Thereby, as shown in FIG. 1, the thermal expansion-resistant resin shell 12 having a uniform thickness t2 can easily formed on the surface of the sphere 11 formed of the elastic body.

When the thermal expansion-resistant resin shell 12 is composed of a resin having properties of a tensile strength of 1 to 700 MPa at a temperature of -40°C to 400°C and a heat resistance of 200°C or more, the coefficient of linear thermal expansion of the thermal expansion-resistant resin shell 12 is nearly the same as that of metal. Therefore, the conductive metal shell 13 formed on the thermal expansion-resistant resin shell 12 can be prevented from damaging due to the heat expansion of the thermal expansion-resistant resin shell 12. Since the tensile strength of the thermal expansion-resistant resin shell 12 is relatively high, when the thickness t2 of the thermal expansion-resistant resin shell 12 is from 1% to 20% of the diameter D of the sphere 11, the tensile strength sufficient for the thermal expansion-resistant resin shell 12 can also be obtained. Therefore, the sphere 11 can be prevented from expanding resulting in the rapture of the conductive metal shell 13.

When the thickness t2 of the thermal expansion-resistant resin shell 12 is 1% or more of the diameter D of the sphere 11, the sphere 11 can be prevented from expanding resulting in the rapture of the conductive metal shell 13. When the thickness t2 of the thermal expansion-resistant resin shell 12 is 20% or less of the diameter D of the sphere 11, the coating of the resin becomes easy, and the thermal expansion-resistant resin shell 12 having a uniform thickness can be easily formed and the elastomeric softness can be obtained. Therefore, the range of the thickness of the thermal expansion-resistant resin shell 12 is preferably from 1% to 20% of the diameter D of the sphere 11, and more preferably from 2% to 10%, and further preferably from 3% to 6% of the diameter D of the sphere 11.

The outer surface of the thermal expansion-resistant resin shell 12 is coated with the conductive metal shell 13. The formation of the conductive metal shell 13 is similar to that in the production of the conventional solder ball, and can be performed by vapor deposition of metal on the outer surface of the thermal expansion-resistant resin shell 12, or by forming the conductive metal shell 13 on the outer surface of the thermal expansion-resistant resin shell 12 by non-electrolytic plating.

The conductive metal shell 13 may be any metal as long as it has conductivity. However, considering the use of the conductive ball 10 of the present invention as the connector between electrodes, the conductive metal shell 13 is preferably formed of copper, gold, silver or palladium, or a metal containing it as a major component which has low electric resistance and good plastic deformation properties. The term "major component" means a component in which it is contained in an amount of 50% or more by weight. The conductive ball 10 having the conductive metal shell 13 can sufficiently decrease the conductive resistance, and can be sufficiently used as the connector by intervening between electrodes to apply a current between them with relatively high conductivity.

In this case, when the thickness t1 of the conductive metal shell 13 is 0.1% or more of the diameter D of the sphere 11, sufficient conductivity can be obtained. When the thickness t1 of the conductive metal shell 13 is 10% or less of the diameter D of the sphere 11, the conductive metal shell 13 can be easily formed, and the damage due to the deformation is prevented, and the elastomeric softness can be obtained. Therefore, the preferable range of the thickness of the conductive metal shell 13 is from 0.1% to 10% of the diameter D of the sphere 11, the more preferable range of the thickness is from 0.5% to 5%, and the further preferable range of the thickness is from 1% to 3% of the diameter D of the sphere 11.

Next, the action and effect of the conductive ball of the present invention will be described when the ball is used as the connector.

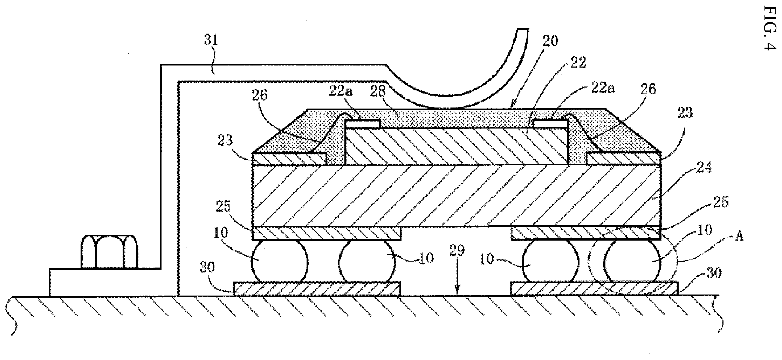

FIG. 4 shows a case in which the conductive ball 10 of the present invention is used as a connecter which connects between an electrode 25 of an IC package 20 and an electrode 30 of a mounting substrate 29.

In the IC package 20 as shown in FIG. 4, a semiconductor chip 22 is mounted on a resin substrate 24 having an upper electrode 23, and a bonding wire 26 is connected between a pad 22a mounted on the semiconductor chip 22 and the upper electrode 23. The semiconductor chip 22 on the resin substrate 24, the bonding wire 26 and the upper electrode 23 are sealed with a sealing resin 28. A lower electrode 25 is formed on the lower surface of the resin substrate 24, which applies a current to the upper electrode 23.

On the other hand, a metal electrode 30 is formed on the surface of the mounting substrate 29, and the metal electrode 30 formed on the mounting substrate 29 and the lower electrode 25 mounted on the IC package 20 are positioned oppositely. The conductive ball 20 of the present invention is inserted between the metal electrode 30 and the lower electrode 25, and used as a connector which electrically connects between the metal electrode 30 and the lower electrode 25.

In this embodiment, the IC package 20 is pressed on the mounting substrate 29 by a metal fitting 31. Specifically, the IC package 20 is mounted on the mounting substrate 29 while the conductive ball 10 is intervened between the metal electrode 30 and the lower electrode 25, and the IC package 20 mounted on the mounting substrate 29 is pressed on the mounting substrate 29 by the metal fitting 31.

When the IC package 20 is pressed on the mounting substrate 29, as shown in FIG. 2, the conductive ball 10 intervening between the respective electrodes 25 and 30 is pressed from both of electrodes 25 and 30. The conductive metal shell 13 formed on the outermost peripheral of the pressed conductive ball 10 is contacted with the lower electrode 25 of the IC package 20 and the metal electrode 30 of the mounting substrate 29 to apply a current and electrically connect between them. Thereby, the conductive ball 10 acts as the connecter which applies a current between electrodes 25 and 30.

The conductive ball 10 of the present invention has the sphere 11 formed of the elastic body; the thermal expansion-resistant resin shell 12 applied so as to coat the surface of the sphere 11; and the conductive metal shell 13 applied so as to coat the outer surface of the thermal expansion-resistant resin shell 12. Therefore, in the conductive ball 10 of the present invention, the conductive ball 10 does not crash when the conductive ball 10 is intervened between electrode 25 and 30 because of the presence of the sphere 11.

Since the sphere 11 is formed of the elastic body, the conductive ball 10 has low elastic modulus. Therefore, when the conductive ball 10 is sandwiched and pressed between the flat surface of electrodes 25 and 30, the conductive metal shell 13 contacted with electrodes 25 and 30 of the conductive ball 10 is easily deformed elastically to be in a surface contact with electrodes 25 and 30. Thereby, the contact area between the conductive metal shell 13 and electrodes 25 and 30 is increased.

In this case, when the conductive metal shell 13 is formed of copper, gold, silver, palladium, or alloy containing it as a major component, the conductivity of the conductive metal shell 13 is increased. When the thickness t1 of the conductive metal shell 13 is from 0.1% to 10% of the diameter D of the sphere 11, the electrical resistance can be sufficiently decreased, and the conductive ball 10 can be sufficiently used as the connector by intervening between electrodes 25 and 30 to apply a current between them with relatively high conductivity.

For making a product by using the IC package 20, the IC package 20 may be sometimes heated, or may be used in the product in the predetermined temperature cycle. In this case, the distance T (FIG. 2) between the lower electrode 25 of the IC package 20 and the metal electrode 30 of the mounting substrate 29 may be changed, or if not, each position can be deviated.

When the distance T between the lower electrode 25 and the metal electrode 30 is changed, the distance T is compensated by deforming elastically the sphere 11 formed of the elastic body. The elasticity of the sphere 11 formed of the elastic body acts so as to press the conductive metal shell 13 on the surface of the sphere 11 against the electrode 25 and 30. Thereby, in the conductive ball 20, even if the distance T between the lower electrode 25 and the metal electrode 30 is changed, the conductive metal shell 13 is not separated from electrodes 25 and 30. Therefore, the lower electrode 25 of the IC package 20 and the metal electrode 30 of the substrate 24 can be stably connected electrically with low electric resistance.

The conductive ball 10 is sandwiched with electrodes 25 and 30 and the conductive metal shell 13 formed on the outermost peripheral thereof is in a surface contact with them, but the conductive metal shell 13 is not mechanically bonded to electrodes 25 and 30. Therefore, when the relative positions of the lower electrode 25 of the IC package 20 and the metal electrode 30 of the substrate 24 are changed, the conductive ball of the present invention moves in corporation with electrodes 25 and 30 while being sandwiched between them and contacting with them. After the conductive ball moves, the conductive metal shell 13 is in a surface contact with electrodes 25 and 30 of the conductive ball 10, likely the conductive ball before moving. Therefore, the lower electrode 25 of the IC package 20 and the metal electrode 30 of the mounting substrate 29 can be stably connected electrically without changing the conductivity of the conductive ball 10 even if the relative positions of their electrodes are changed.

The coefficient of thermal expansion of the elastic body as the component of the sphere 11 is sometimes higher than that of metal as the component of the metal shell 13. When the thermal expansion of the sphere 11 is bigger than that of the metal shell 13, the metal shell 13 which electrically connects between electrodes is cracked, and the electrical resistance is increased.

However, in the conductive ball 10 of the present invention, the surface of the sphere 11 formed of the elastic body is coated with the thermal expansion-resistant resin shell 12. Therefore, when the conductive ball 10 intervening between electrodes 25 and 30 is heated, the significant heat expansion of the sphere 11 cam be prevented by the thermal expansion-resistant resin shell 12. In particular, when the thermal expansion-resistant resin shell 12 is formed of a resin having properties of a tensile strength of 1 to 700 MPa at a temperature of -40°C to 400°C and a heat resistance of 200°C or more, for example, a polyimide, the coefficient of linear thermal expansion of the polyimide is nearly the same as that of metal. When the thickness t2 of the thermal expansion-resistant resin shell 12 is from 1% to 20% of the diameter D of the sphere 11, the tensile strength sufficient for the thermal expansion-resistant resin shell 12 can also be obtained.

Therefore, even if the conductive ball 10 of the present invention is heated during the production or by the following thermal history, since the sphere 11 formed of the elastic body is prevented from expanding beyond the heat expansion of the conductive metal shell 13 by the presence of the thermal expansion-resistant resin shell 12, the sphere 11 can be prevented from expanding resulting in the rapture of the conductive metal shell 13 formed on the outer surface of the thermal expansion-resistant resin shell 12.

Polyimides have a nitrogen compound in the molecular structure, and the nitrogen compound is known to be bonded to metal relatively strongly. Therefore, when the thermal expansion-resistant resin shell 12 is formed of a polyimide, the thermal expansion-resistant resin shell 12 formed of a polyimide is mechanically bonded with the conductive metal shell 13 formed on the outer surface of the thermal expansion-resistant resin shell 12 strongly, and the conductive metal shell 13 can be prevented from releasing from the thermal expansion-resistant resin shell 12.

Therefore, when the conductive ball 10 of the present invention is used as the connector by intervening between electrodes 25 and 30 to apply a current between them with relatively high conductivity, the conductivity is not decreased due to the following thermal history.

When the diameter D of the sphere 11 (FIG. 1) is from 0.4 to 2 mm, a plurality of the sphere 11 having a relatively uniform diameter can be obtained, and the conductive ball 10 of the present invention can be easily produced. When the sphere 11 is formed of a silicone rubber, and the silicone rubber has a heat resistance of 200°C or more, and preferably 250°C or more, the usable temperature range of the conductive ball 10 of the present invention can be remarkably widened.

In the embodiment as described above, with reference to FIGS. 2 and 4, it is described that the conductive ball 10 of the present invention is used as the connector by being sandwiched between electrodes 25 and 30 to apply a current between them. However, the conductive ball 10 of the present invention may be used as the conventional solder ball which is connected with electrodes 25 and 30.

In the embodiment as described above, with reference to FIG. 4, it is described that the IC package 20 having the conductive ball 10 of the present invention sandwiched between electrodes 25 and 30 is fixed by the metal fitting 31. However, when the conductive ball 10 of the present invention is used as the connector by being sandwiched between electrodes 25 and 30 to apply a current between them, the fixing structure for the IC package 20 and the conductive ball 10 itself is not limited to the metal fitting 31, and the structure may be any structure as long as the deviation of the conductive ball 10 sandwiched between electrodes 25 and 30 from the intervening between electrodes 25 and 30 is prohibited. For example, the fixing structure may be bonding or adhesion.

In the embodiment as described above, with reference to FIG. 3, it is described that the sphere 11 and the thermal expansion-resistant resin shell 12 are formed by supplying a liquid resin 12a for the thermal expansion-resistant resin shell 12 and a liquid elastic body 11 to be embodied in the thermal expansion-resistant resin shell 12 to the continuous flow of the aqueous medium 14. However, the method of the formation is only one example, and the method is not limited to the example as long as the thermal expansion-resistant resin shell 12 can be formed on the surface of the sphere 11. For example, the method may be two step polymerization or coating.

For the formation of the thermal expansion-resistant resin shell 12, in the embodiment as described above, as shown in FIG. 3, the liquid resin and the liquid elastic body are flowed in parallel. When the liquid resin 12a the liquid elastic body 11 are supplied to the continuous flow of the aqueous medium 14, they may be flowed in non-parallel as long as the thermal expansion-resistant resin shell 12 can be formed on the surface of the sphere 11, and the liquid resin and the liquid elastic body may be flowed separately from different positions.

### EXAMPLES

### <Example>

A conductive ball 10 having a structure as shown in FIG. 1 was produced. In this Example, the sphere 11 was formed of a silicone rubber (the heat resistance is 400°C), the thermal expansion-resistant resin shell 12 was formed of a polyimide (the heat resistance is 350°C), and the conductive metal shell 13 was formed by plating with copper/nickel/gold in this order. The diameter D of the sphere 11 was 0.29 mm, the thickness t2 of the thermal expansion-resistant resin shell 12 was 15 µm, which corresponds to 5% of the diameter D of the sphere 11, and the thickness t1 of the conductive metal shell 13 was 5 µm, which corresponds to 2% of the diameter D of the sphere 11. The sphere 11 had an elastic modulus so that the diameter D was decreased by 10% when a flat electrode was placed on the sphere at a load of 2 g to 5 g.

### <Comparative Example>

A conductive ball was produced in the same manner as in the Example except that the thermal expansion-resistant resin shell was not formed. Since the sphere formed of a silicone rubber cannot be plated with metal directly, the conductive metal shell was formed by coating copper/nickel/gold in this order by means of sputtering.

### <Evaluation>

Each conductive ball produced in the Example and the Comparative Example was heated for 5 min, and then cooled to room temperature. After that, the condition of the coating of the conductive ball was observed with a microscope. The heating temperature was 50°C, 100°C, 150°C, 200°C, and 250°C. The results are shown in TABLE 1. It is noted that the conductive ball in the Example and the Comparative Example have different appearances because the methods for forming the conductive metal shell were different from each other.

**TABLE 1**

| | Example | Comparative Example |
|---|---|---|
| Initial | 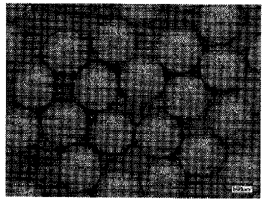 | 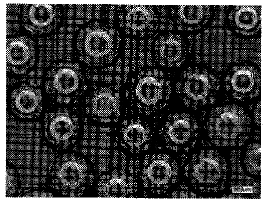 |
| 50°C | 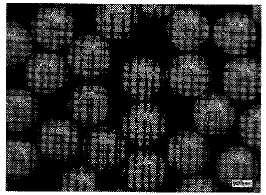 | 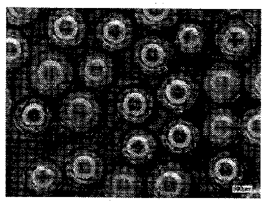 |
| 100°C | 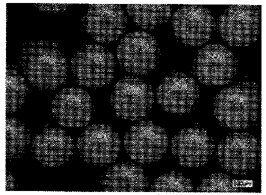 | 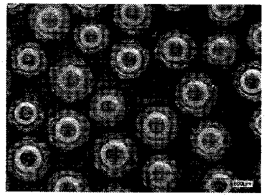 |
| 150°C | 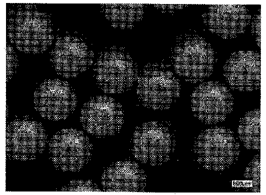 | 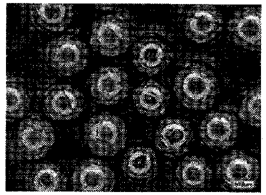 |
| 200°C | 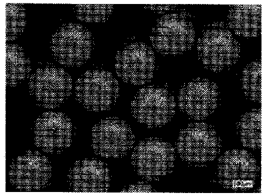 | - |
| 250°C | 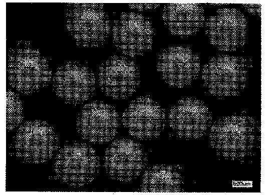 | - |

As shown above, the conductive ball obtained in the Example had no distortion and no crack in the coating even if it was heated to 250°C. In contrast, the conductive ball obtained in the Comparative Example became expanded at 100°C, and was distorted or cracked when it was heated to 150°C. Therefore, it indicates that the decrease of the conductivity due to the thermal history is prevented according to the present invention.

In the conductive ball of the present invention, since the outer surface of the sphere formed of an elastic body is coated with the conductive metal shell, the conductive ball has low elastic modulus. Thus, when the conductive ball is pressed on a flat electrode, the contact area of the conductive ball with the electrode is easily deformed elastically to be in surface contact with the electrode. Thereby, the contact area between the conductive metal shell formed on the outer surface of the conductive ball and the electrode is increased, and the conductive ball can apply a current to the pressed electrode with relatively high conductivity.

In this case, when the conductive metal shell is formed of copper, gold, silver, palladium, or alloy containing it as a major component, the conductivity of the conductive metal shell is increased. When the thickness of the conductive metal shell is from 1% to 20% of the diameter of the sphere, the electrical resistance can be further decreased, and the conductive ball can be sufficiently used as the connector by intervening between electrodes to apply a current between them with relatively high conductivity.

The coefficient of thermal expansion of the elastic body as the component of the sphere is generally higher than that of metal as the component of the metal shell. However, since the surface of the sphere formed of the elastic body is coated with the thermal expansion-resistant resin shell in the conductive ball of the present invention, the significant heat expansion of the sphere is prevented by the thermal expansion-resistant resin shell.

In particular, when the thermal expansion-resistant resin shell is composed of a resin having properties of a tensile strength of 1 to 700 MPa at a temperature of -40°C to 400°C and a heat resistance of 200°C or more, for example, a polyimide, the coefficient of linear thermal expansion is nearly the same as that of metal. When the thickness of the thermal expansion-resistant resin shell is from 1% to 20% of the diameter of the sphere, the tensile strength sufficient for the thermal expansion-resistant resin shell can also be obtained. Therefore, even if the temperature of the conductive ball is increased during the production or by the following thermal history, the sphere formed of the elastic body is prevented from expanding beyond the heat expansion of the conductive metal shell by the presence of the thermal expansion-resistant resin shell, and the sphere can be prevented from expanding resulting in the rapture of the conductive metal shell formed on the outer surface of the thermal expansion-resistant resin shell.

When the diameter of the sphere is from 0.04 to 2 mm, a plurality of the sphere 11 having a relatively uniform diameter can be obtained, and the conductive ball of the present invention can be easily produced. When the sphere is formed of a silicone rubber, and the silicone rubber has a heat resistance of 200°C or more, the usable temperature range of the conductive ball of the present invention can be remarkably widened.

Thereby, the present invention provides a conductive ball which can be used as the connector by intervening between electrodes to apply a current between them with relatively high conductivity and which is prevented from decreasing the conductivity due to the following thermal history because the conductive metal shell for applying a current between electrodes is not ruptured due to the following thermal history.

### DENOTATION OF REFERENCE NUMERALS

- 10: conductive ball
- 11: sphere
- 12: thermal expansion-resistant resin shell
- 13: conductive metal shell

## Claims

1. A conductive ball comprising:
a sphere (11) formed of a rubber, which has a diameter (D) of 0.04 to 2 mm;
a thermal expansion-resistant resin shell (12) applied so as to coat the surface of the sphere (11), which is formed of a polyimide or a material containing a polyimide; and
a conductive metal shell (13) applied so as to coat the outer surface of the thermal expansion-resistant resin shell (12).

2. The conductive ball according to claim 1, wherein the rubber has a heat resistance of 200°C or more.

3. The conductive ball according to any one of claims 1 to 2, wherein the thermal expansion-resistant resin shell (12) is formed of a resin, which has properties of a tensile strength of 1 to 700 MPa at a temperature of -40°C to 400°C and a heat resistance of 200°C or more.

4. The conductive ball according to any one of claims 1 to 3, wherein the thickness (t2) of the thermal expansion-resistant resin shell (12) is from 1% to 20% of the diameter (D) of the sphere (11).

5. The conductive ball according to any one of claims 1 to 4, wherein the conductive metal shell (13) is formed of copper, gold, silver, or palladium, or an alloy containing it.

6. The conductive ball according to any one of claims 1 to 5, wherein the thickness (t1) of the conductive metal shell 13 is from 0.1% to 10% of the diameter (D) of the sphere (11).

## Patentansprüche

1. Leitfähiger Ball, umfassend:
eine Kugel (11), gebildet aus einem Kautschuk, die einen Durchmesser (D) von 0,04 bis 2 mm aufweist;
eine gegenüber thermischer Ausdehnung resistenten Harzhülle (12), die so angebracht ist, dass sie die Oberfläche der Kugel (11) beschichtet, die aus einem Polyimid oder einem Material, das ein Polyimid enthält, gebildet ist; und
eine leitfähige Metallhülle (13), die so angebracht ist, dass sie die gegenüber thermischer Ausdehnung resistente Harzhülle (12) beschichtet.

2. Leitfähiger Ball nach Anspruch 1, wobei der Kautschuk eine Hitzebeständigkeit von 200 °C oder mehr aufweist.

3. Leitfähiger Ball nach einem der Ansprüche 1 bis 2, wobei die gegenüber thermischer Ausdehnung resistente Harzhülle (12) aus einem Harz gebildet ist, das Eigenschaften einer Zugfestigkeit von 1 bis 700 MPa bei einer Temperatur von -40 °C bis 400 °C und eine Hitzebeständigkeit von 200 °C oder mehr aufweist.

4. Leitfähiger Ball nach einem der Ansprüche 1 bis 3, wobei die Dicke (t2) der gegenüber thermischer Ausdehnung resistenten Harzhülle (12) von 1 % bis 20 % des Durchmessers (D) der Kugel (11) beträgt.

5. Leitfähiger Ball nach einem der Ansprüche 1 bis 4, wobei die leitfähige Metallhülle (13) aus Kupfer, Gold, Silber oder Palladium oder einer Legierung, die dies beinhaltet, gebildet ist.

6. Leitfähiger Ball nach einem der Ansprüche 1 bis 5, wobei die Dicke (t1) der leitfähigen Metallhülle 13 von 0,1 % bis 10 % des Durchmessers (D) der Kugel (11) beträgt.

## Revendications

1. Bille conductrice comprenant :
une sphère (11) constituée d'un caoutchouc possédant un diamètre (D) allant de 0,04 à 2 mm ;
une coque en résine résistante à la dilatation thermique (12) appliquée de façon à revêtir la surface de la sphère (11), qui est constituée d'un polyimide ou d'un matériau contenant un polyimide ; et
une coque métallique conductrice (13) appliquée de façon à revêtir la surface externe de la coque en résine résistante à la dilatation thermique (12).

2. Bille conductrice selon la revendication 1, ledit caoutchouc possédant une résistance à la chaleur supérieure ou égale à 200°C.

3. Bille conductrice selon l'une quelconque des revendications 1 à 2, ladite coque en résine résistant à la dilatation thermique (12) étant constituée d'une résine, qui possède des propriétés de résistance à la traction allant de 1 à 700 MPa à une température allant de -40°C à 400°C et une résistance thermique supérieure ou égale à 200°C.

4. Bille conductrice selon l'une quelconque des revendications 1 à 3, ladite épaisseur (t2) de la coque en résine résistante à la dilatation thermique (12) allant de 1 % à 20 % du diamètre (D) de la sphère (11).

5. Bille conductrice selon l'une quelconque des revendications 1 à 4, ladite coque métallique conductrice (13) étant constituée de cuivre, d'or, d'argent ou de palladium, ou d'un alliage contenant l'un de ces métaux.

6. Bille conductrice selon l'une quelconque des revendications 1 à 5, ladite épaisseur (t1) de la coque métallique conductrice (13) allant de 0,1 % à 10 % du diamètre (D) de la sphère (11).
